# EUROPEAN PATENT SPECIFICATION

(11) **EP 3 148 299 B1**
(45) Date of publication and mention of the grant of the patent: **16.03.2022**
(21) Application number: 16191243.1
(22) Date of filing: 28.09.2016
(51) Int. Cl.: H05K 1/03, B29C 45/14, H05K 3/00, H05K 3/28

(54) **A TEXTILE MULTI-LAYERED INJECTION-MOULDED ARTICLE COMPRISING CONDUCTIVE CIRCUIT TRACES**
TEXTILER MEHRSCHICHTIGER SPRITZGUSSARTIKEL MIT LEITERBAHNEN
ARTICLE MOULÉ PAR INJECTION MULTICOUCHE TEXTILE COMPRENANT UN CIRCUIT IMPRIMÉ

(30) Priority: 28.09.2015 PT 10884215
(43) Date of publication of application: 29.03.2017
(73) Proprietor: Simoldes Plásticos, SA, Oliveira de Azeméis (PT)
(72) Inventor: MAGALHÃES RIBEIRO DA CUNHA MELO, Sandra Rafaela, 4450-732 LEÇA DA PALMEIRA (PT); ALVES DA SILVA, Ana Sofia, 4430-548 VILA NOVA DE GAIA (PT); SIMÕES COSTA, Hugo Filipe, 4760-689 VILA NOVA DE FAMALICÃO (PT); GONÇALVES, António Miguel, 4770-277 JOANE (PT); OLIVEIRA DA SILVA, José Fernando, 4445 ALFENA (PT); DE CARVALHO GOMES, João Manuel, 4700-832 RUÍLHE (PT); TRINDADE MORGADO RODRIGUES, Lúcia, 4800-039 GUIMARÃES (PT); CAMPOS DE OLIVEIRA, Cristina Manuela, 4805-019 BRITO (PT); DE SOUSA BESSA SOARES, João Luís, 4470-051 MAIA (PT); CALIFÓRNIA MARQUES, António Fernando, 4720-408, Amares (PT)
(74) Representative: Patentree

(56) References cited:
- EP-A1- 1 886 788
- EP-A1- 3 065 516
- DE-A1- 10 143 883
- GB-A- 1 361 242
- JP-A- H06 212 549
- JP-A- 2015 094 995
- US-A1- 2002 076 948

## Description

### Technical domain

The present disclosure relates to a multi-layered textile structure with printed electronic circuits, in particular for lighting and sensing performances for the interior of a vehicle, skilled to be moulded into a high quality component by injection process or used in injected thermoplastic component coverings. The present disclosure also relates to the processes to obtain the novel multi-layered textile structure and final articles.

The present disclosure can have several applications namely for a new sensorized and lighting articles, in particular articles for the automotive industry.

### Technical background

The US 7301351 B2 refers to a flexible capacitive sensor. The sensor comprises a dielectric, an electrically conductive detector and trace layer on the first side of the dielectric layer comprising a detector and trace, an electrically conductive reference layer on a second side of the dielectric layer, and a capacitance meter electrically connected to the trace and to the conductive reference layer to detect changes in capacitance upon interaction with detector.

The WO 2014135958 A1 discloses a method of printing electronic systems on textile substrates by screen printing, comprising the use of primers, insulating materials such as dielectrics, conductive materials, resistive materials, magnetic materials, electroluminescent materials, thermoelectrical materials and electronic components. JP 2015 094995 A discloses a textile multi-layered injection-moulded article including printed circuit traces. It does not disclose an adhesive non-woven fabric layer for stabilizing and protecting the printed electric circuit during injection-moulding process.

The documents previously mentioned are related with electronic flexible materials and printed electronic systems integrated on textile substrates. However, there were not found specific solutions aiming at overcome the demanding technical requirements involved in injection processes.

Injection process involves high pressure and temperature values, requiring that materials to be injected must be very carefully selected and designed.

The present disclosure intends to respond to automotive sector trends regarding to the reduction of weight, duration/cost of assembly process and enhancement of flexibility in terms of functionalities and design.

Printed electronic circuits allow a reduction in weight and volume when compared to conventional electronic integration processes.

The present innovation refers to the integration of sensing-actuating, lighting, and printed circuits solutions directly into injection moulded parts through the incorporation of the circuits and electronic devices in the multi-layered textile fabric used in injection processes.

These facts are disclosed in order to illustrate the technical problem addressed by the present disclosure.

### General description

The solution now presented relates to a multi-layered textile structure with printed electronic circuits, in particular lighting and skilled to be moulded into an interior car component by injection process and to a production method thereof. This disclosure is an innovative and differentiated approach.

The present disclosure is achieved using a lamination process and an injection moulding.

Lamination is a technique of manufacturing a material in multiple layers allowing to achieve improved strength, stability, sound insulation, appearance or other properties from the use of differing materials. A multi-layered structure is usually assembled by heat, pressure, welding, and/or adhesives.

Injection moulding is a manufacturing process for producing parts/elements by injecting a material into a mould. The injection moulding process can use several materials, including metals, glasses, thermoplastics, thermosetting and elastomers polymers, and textiles.

The industry, namely automotive industry, is looking for new sensorized materials that are easy to assemble and correspond to the quality requirements. One of the objectives of this disclosure is to describe an article that could combine in the same object a luminescent component/ electronic component , a textile and an injection moulded material using a conventional injection moulding process, in particular an article not showing the internal structure thorough the outer textile layer, and also an article that answer to the automotive quality standard tests - namely resistance to rupture, cracking, abrasion cleaning test, visual aspect, flexibility, among others.

The present invention is related to a textile multi-layered injection-moulded article according to claim 1.

According to the invention, the outer laminated textile fabric and the laminated foil have been attached using injection-moulding.

In an embodiment, the moulded article comprises a bi-adhesive layer to attach said laminated foil to the laminated textile fabric.

In an embodiment, the laminated foil has been laminated together with the outer laminated textile fabric.

In an embodiment, the moulded article may comprise one or more electronic components disposed on the same side of the adhesive non-woven fabric layer or of the polymeric film layer and disposed on the circuit trace or traces, said components being electrically connected to said circuit trace or traces and said electronic components have also been laminated together in the laminated foil.

In an embodiment, the electronic components can be light-emitting diode, an electroluminescence lamp, an electric resistance, a resistor sensor, light-emitting diodes (LEDs), organic light-emitting diode (OLED),a crimping element or combinations thereof, among others.

In an embodiment, the laminated textile fabric layer of the moulded article may be a single textile fabric or a combination of at least two fabric layers. In particular, the combination of fabric layers may be: a knit as decorative textile and a non-woven fabric or, a woven fabric as decorative textile and non-woven fabric. More in particular, the textile fabric layer may be selected from the following list: knit fabrics, woven fabrics, synthetic leather, nonwoven fabrics or combinations thereof.

In an embodiment the bi-adhesive layer may have a melting temperature range between 115 - 143 °C.

In an embodiment the bi-adhesive layer may have a weight between 5 - 50 g/m2, preferably 20 g/m2.

In an embodiment the bi-adhesive layer may be selected from the following list: polyurethane, polyamide, polyester, ethylene-vinyl acetate, or combinations thereof, among others.

In an embodiment, the polymeric film and/or the encapsulation layer, may have a thickness from 20 to 70 µm, preferably 50 µm.

In an embodiment, the polymeric film and/or the encapsulation layer, may have a density at 20 °C from 1.1 to 1.2 g/cm3.

In an embodiment, the polymeric film and/or the encapsulation layer, may have a melting temperature range from 145 to 210 °C.

In an embodiment, the polymeric film or the encapsulation layer, may be selected from a list consisting of polyurethane material, polyurethane, polyester, polyamide, polyether, ethylene-vinyl acetate or combinations thereof, among others.

In an embodiment, the adhesive non-woven fabric layer may have a weight between 20 - 100 g/m2, preferably around 75 g/m2.

According to the invention, the adhesive non-woven fabric layer has a thickness between 200 - 300 µm.

In an embodiment, the adhesive non-woven fabric layer may be selected from the following list: polyethylene terephthalate preferably coated with low-density polyethylene, polyurethane, polyamide, polyester, or combinations thereof.

In another embodiment the moulded article may be a car pillar, a car door panel, a car door, a car armrest, a car console, a car instrument panel, a car glove box compartment, a car trunk door, a car trunk panel, or baby car seat or an electric home appliance.

Another aspect of the present invention is related to a car, a train, a boat or an aeroplane comprising the moulded article of the present subject-matter.

In a preferred embodiment according to claim 1, the multi-layered textile structure which integrates an electric circuit may comprise at least 5 layers, in particular 7 layer, in particular:
- layer 1 is an outer laminated textile fabric, in particular a combination of at least two 2 fabric layers. The 2 fabric layers combination can be a knit as decorative textile and a non-woven fabric or, a woven-fabrics as decorative textile and non-woven fabric;
- optionally a layer 2 is a bi-adhesive material for attaching layer 1 to another layer;
- layer 3 is a polymeric adhesive film used for electric printed circuits encapsulation;
- layer 4 is an adhesive non-woven fabric to carrier an electric printed circuits, previously performed; and used to stabilize and protect electric circuits from the high temperature and pressure applied during injection moulding processes.

The bi-adhesive material may comprise polyurethane, polyamide, polyester, ethylene-vinyl acetate; in particular with weight between 5 - 50 g/m², preferably 20 g/m², and melting temperature range between 115 - 143 °C.

The polymeric film or the encapsulation layer, can be made by polyurethane, polyester, polyamide, polyether or ethylene-vinyl acetate, with a thickness of 20 - 70 µm, preferably 30 µm, a melting temperature range between 145 - 210 °C and a density of 1.1 - 1.2 g/cm³ at 20°C.

The adhesive non-woven fabric layer can be made by single and bi-component fibres, preferably polyethylene terephthalate (PET) coated with low-density polyethylene (LDPE), with a thickness between 200 - 300 µm and weight 20 - 100 g/m², preferably around 75 g/m².

The term "comprising" whenever used in this document is intended to indicate the presence of stated features, integers, steps, components, but not to preclude the presence or addition of one or more other features, integers, steps, components or groups thereof.

### Brief description of the drawings

**Figure 1****:** Illustration of the final textile multi-layered structure, before injection moulding according to an example not part of the invention, wherein:
   (1) represents the outer laminated textile fabric;
   (2) represents the bi-adhesive material;
   (3) represents the polymeric adhesive film for printed circuits encapsulation;
   (5) represents the adhesive non-woven fabric layer with printed circuits;
   (7) represents the printed circuit.
**Figure 2****:** Main process phases for achieving the final multi-layered textile structure of figure 1 with the laminated foil before injection moulding.
**Figure 3****:** Illustration of a textile multi-layered structure to form the moulded article according to an embodiment of the invention, before injection moulding, wherein:
   (1) represents the outer laminated textile fabric;
   (2) represents the bi-adhesive material;
   (3) represents the adhesive film for printed circuits encapsulation;
   (4) represents the adhesive film with printed circuits;
   (5) represents the adhesive non-woven fabric layer;
   (6) represents the polyethylene film carrier;
   (7) represents the printed circuit.

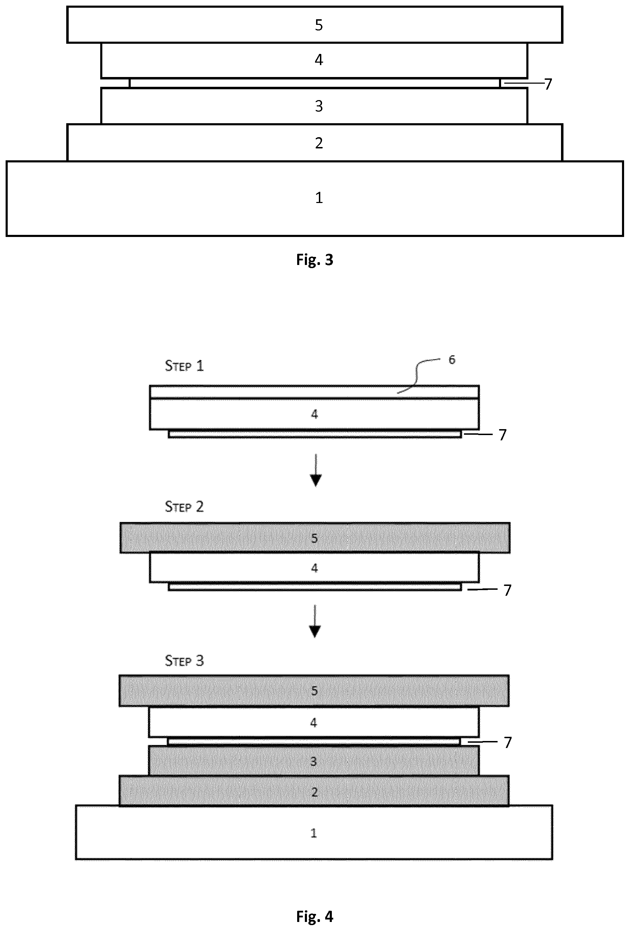

**Figure 4****:** Main process phases for achieving the final multi-layered textile structure of figure 3 with the laminated foil before injection moulding.

### Detailed Description

The present disclosure relates to a multi-layered textile structure with printed electronic circuits, in particular for lighting and sensing performances for the interior of a vehicle, skilled to be moulded into a high quality component by injection process or used in injected thermoplastic component coverings. The present disclosure also relates to the processes to obtain the novel multi-layered textile structure and final articles.

A method for producing the final multi-layered textile structure may comprise the following steps:
step 1: printing electronic circuit(s) (7) on a side of the adhesive non-woven fabric layer (5), in particular polyethylene terephthalate coated with low-density polyethylene, or combinations thereof;
step 2: adhering the adhesive non-woven fabric layer with printing electronic circuit(s) (7) to the adhesive film layer (3) for the encapsulation printed electronic circuits;
step 3: lamination of the remaining layers in order to achieve the final multi-layered structure.

A method for producing the final multi-layered textile structure may comprise the following steps:
step 1: printing electronic circuit(s) on a polymeric film layer, in particular a polyurethane film layer (4);
step 2: adhering the adhesive non-woven fabric layer (5) to the polymeric film layer with printed electronic circuits (4);
step 3: lamination of the remaining layers in order to achieve the final multi-layered structure.

In an embodiment, the printing of the electric circuit (7) is by sheet-to-sheet screen-printing technology, in semi-automatic mode. The conductive circuits are printed, allowing electrical conduction, with conductive ink, which will include electronic components, in particular light-emitting diodes (LEDs), electroluminescence lamps, sensors, electric resistances, crimping elements, or combinations thereof.

The second step of the method for producing the final multi-layered textile structure, the carrier of the adhesive film is removed and this layer is laminated with the adhesive non-woven fabric layer (5) with printing electronic circuits (7). To carry out this lamination, a flat press may be used with the following process parameters:
- Temperature = 60 - 150 °C, preferably 100 °C;
- Pressure = 0.5 - 5 bar, preferably 2 bar;
- Time = 2 -10 s, preferably 5 s.

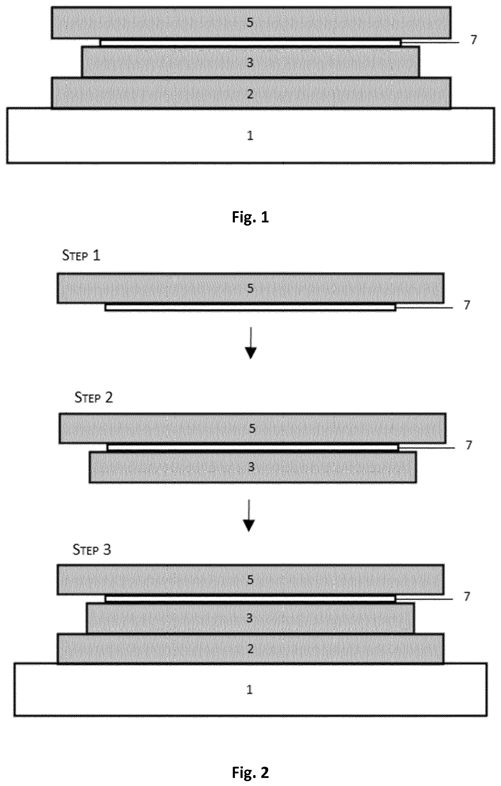

The third step of the method for producing the final multi-layered textile structure, the bi-adhesive material (2) and an adhesive non-woven fabric layer (5) with printed electronic circuits (7) laminated with the polymeric film for printed circuits encapsulation (3); are prepared according to the proper dimensions and formats and placed on top of each other following a studied and predefined place outer laminated textile fabric (1). The layers position in the final structure is presented in figure 2.

The third step of the method for producing the final multi-layered textile structure, the bi-adhesive material (2) and an adhesive non-woven fabric layer (5) are prepared according to the proper dimensions and formats. The polymeric film carrier (6), in particular a removal paper, of the previously bonded structure (produced in step 2) is removed and all the layers are placed on top of each other following a studied and predefined place outer laminated textile fabric (1). The layers position in the final structure is presented in figure 4.

In an embodiment, the specific place on the laminated foil can be defined by conventional techniques, avoiding critical points such as injection points, component type and the final purpose and functions.

In an embodiment, the lamination can be made with a flat press using the following process parameters:
- Temperature = 80 - 200 °C, preferably 150 °C;
- Pressure = 0.5 - 8 bar, preferably 4 bar;
- Time = 2 - 30 s, preferably 15 s.

The automotive components can be obtained using the novel multi-layered structure which can be moulded by injection process or through the lamination with a thermoplastic moulded component.

The injection or lamination process can be performed in the same conditions of conventional structures. In fact, the injection process does not suffer any changes compared with conventional process. The injection process parameters depend on the:
- thermoplastic material;
- melting mass temperature at injection;
- injection time;
- injection pressure;
- closing force.

The developed solution can have several applications in the automotive industry, namely: lighting, sensing; decorative lighting/low lighting.

The invention is, of course, not in any way restricted to the embodiments described and a person with ordinary skill in the art will foresee many possibilities to modifications thereof without departing from the basic idea of the invention as defined in the appended claims.

## Claims

1. A moulded article obtainable by injection moulding of a textile multi-layered structure, the textile multi-layered structure comprising the following layers stacked in the order mentioned below:
an outer laminated textile fabric (1);
an optional bi-adhesive material (2); and
a laminated foil (3, 7, 4, 5), wherein said laminated foil comprises: one or more electrically conductive circuit traces (7), an encapsulation layer for printed circuits encapsulation (3); a polymeric film layer (4), on which side the one or more electrically conductive circuit traces (7) are printed;
an adhesive non-woven fabric layer (5) for stabilizing and protecting the printed electric circuit during injection-moulding process, wherein the adhesive non-woven fabric layer (5) has a thickness between 200 - 300 µm; such that the layers of the textile multi-layered structure are attached to one another;
wherein the outer laminated textile fabric (1) and the laminated foil (3, 7, 4, 5) have been attached using injection-moulding thereto.

2. The moulded article according to any of the previous claims wherein the bi-adhesive layer (2) attaches said laminated foil to the outer laminated textile fabric (1).

3. The moulded article according to any of the previous claims wherein all the elements of the laminated foil (3,7,4,5) have been laminated together in the laminated foil (3,7,4,5).

4. The moulded article according to any of the claims 1-3 wherein said laminated foil has been laminated together with the outer laminated textile fabric (1).

5. The moulded article according to any of the previous claims comprising one or more electronic components disposed on the same side of the adhesive non-woven fabric layer (5) or of the polymeric film layer (4) and disposed on the circuit trace or traces said components being electrically connected to said circuit trace or traces and said electronic components having also been laminated together with the laminated foil.

6. The moulded article according to the previous claims wherein the electronic components are a light-emitting diode, an electroluminescence lamp, an electric resistance, a resistor sensor, a crimping element or combinations thereof.

7. The moulded article according to any of the previous claims wherein the textile fabric layer (1) is a combination of at least two fabric layers, preferably wherein the combination of at least 2 fabric layers is: a knit as decorative textile and a non-woven fabric, or a woven-fabric as decorative textile and a non-woven fabric.

8. The moulded article according to any of the previous claims wherein the encapsulation layer (3) and/or the polymeric film layer (4) has a thickness from 20 to 70 µm, preferably 50 µm.

9. The moulded article according to any of the previous claims wherein the encapsulation layer (3) and/or the polymeric film layer (4) has a density at 20 °C from 1.1 to 1.2 g/cm³.

10. The moulded article according to any of the previous claims wherein the encapsulation layer (3) and/or the polymeric film layer (4) has a melting temperature range from 145 to 210 °C.

11. The moulded article according to any of the previous claims wherein the encapsulation layer (3) and/or the polymeric film layer (4) is selected from a list consisting of polyurethane, polyester, polyamide, polyether, ethylene-vinyl acetate or combinations thereof.

12. The moulded article according to the previous claims wherein the bi-adhesive layer (2) has a melting temperature range between 115 - 143 °C and /or the bi-adhesive layer (2) has a weight between 5 - 50 g/m2, preferably 20 g/m2.

13. The moulded article according to the previous claims wherein the article is a car pillar, a car door panel, a car door, a car armrest, a car console, a car instrument panel, a car glove box compartment, a car trunk door, or a car trunk panel, or baby car seat or an electric home appliance.

## Patentansprüche

1. Ein durch Spritzguss herstellbarer Formartikel mit einer mehrschichtigen Textilstruktur, wobei die mehrschichtige Textilstruktur die folgenden Schichten umfasst, die in nachstehend genannter Reihenfolge aufgeschichtet sind:
ein äußeres kaschiertes Textilgewebe (1);
ein optionales beidseitig haftendes Material (2); und
eine kaschierte Folie (3, 7, 4, 5), wobei die genannte kaschierte Folie umfasst: eine oder mehrere elektrisch leitende Leiterbahnen (7), eine Verkapselungsschicht zur Verkapselung gedruckter Schaltungen (3); eine polymere Filmschicht (4), auf deren Seite eine oder mehrere elektrisch leitende Leiterbahnen (7) aufgedruckt sind;
eine haftende Vliesstoffschicht (5) zur Stabilisierung und zum Schutz des aufgedruckten elektrischen Stromkreises während des Spritzgussverfahrens, wobei die haftende Vliesstoffschicht (5) eine Stärke zwischen 200 - 300 µm aufweist; sodass die Schichten der mehrschichtigen Textilstruktur miteinander verbunden sind;
wobei das äußere kaschierte Textilgewebe (1) und die kaschierte Folie (3, 7, 4, 5) durch ein Spritzgussverfahren an diesem befestigt wurden.

2. Der Formartikel nach einem der vorangehenden Ansprüche, wobei die genannte kaschierte Folie über die beidseitige Haftschicht (2) an dem äußeren kaschierten Textilgewebe (1) befestigt wird.

3. Der Formartikel nach einem der vorangehenden Ansprüche, wobei alle Bestandteile der kaschierten Folie (3, 7, 4, 5) in der kaschierten Folie (3, 7, 4, 5) zusammenkaschiert wurden.

4. Der Formartikel nach einem der Ansprüche 1 - 3, wobei die genannte kaschierte Folie mit dem äußeren kaschierten Textilgewebe (1) zusammenkaschiert wurde.

5. Der Formartikel nach einem der vorangehenden Ansprüche, umfassend ein oder mehrere elektronische Bauteile, die auf derselben Seite der haftenden Vliesstoffschicht (5) oder der polymeren Filmschicht (4) angeordnet sind und auf der Leiterbahn oder der Leitbahnen angeordnet sind, wobei die genannten Bauteile mit der genannten Leiterbahn oder den genannten Leiterbahnen elektrisch verbunden sind und die genannten elektronischen Bauteile ebenfalls mit der kaschierten Folie zusammenkaschiert wurden.

6. Der Formartikel nach einem der vorangehenden Ansprüche, wobei die elektronischen Bauteile eine Leuchtdiode, eine Elektrolumineszenz-Lampe, ein elektrischer Widerstand, ein Messwiderstand, ein Crimp-Element oder Kombinationen davon sind.

7. Der Formartikel nach einem der vorangehenden Ansprüche, wobei die textile Gewebeschicht (1) eine Kombination aus mindestens zwei Gewebeschichten ist, wobei die Kombination aus mindestens 2 Gewebeschichten bevorzugt besteht aus: einem Gewirk als dekorative Textilie und einem Vliesstoff, oder einem Gewebe als dekorative Textilie und einem Vliesstoff.

8. Der Formartikel nach einem der vorangehenden Ansprüche, wobei die Verkapselungsschicht (3) und/oder die polymere Filmschicht (4) eine Stärke von 20 bis 70 µm, bevorzugt 50 µm, aufweist.

9. Der Formartikel einem der vorangehenden Ansprüche, wobei die Verkapselungsschicht (3) und/oder die polymere Filmschicht (4) bei 20 °C eine Dichte von 1,1 bis 1,2 g/cm³ aufweist.

10. Der Formartikel nach einem der vorangehenden Ansprüche, wobei die Verkapselungsschicht (3) und/oder die polymere Filmschicht (4) einen Schmelztemperaturbereich von 145 bis 210 °C aufweist.

11. Der Formartikel nach einem der vorangehenden Ansprüche, wobei die Verkapselungsschicht (3) und/oder die polymere Filmschicht (4) aus einer Liste bestehend aus Polyurethan, Polyester, Polyamid, Polyether, Ethylen-Vinylacetat oder Kombinationen davon ausgewählt wird.

12. Der Formartikel nach den vorangehenden Ansprüchen, wobei die beidseitige Haftschicht (2) einen Schmelztemperaturbereich zwischen 115 - 143 °C aufweist und/oder die beidseitige Haftschicht (2) ein Gewicht zwischen 5 - 50 g/m², bevorzugt 20 g/m² aufweist.

13. Der Formartikel nach den vorangehenden Ansprüchen, wobei der Artikel die Säule eines Autos, eine Autotürverkleidung, eine Autotür, eine Autoarmlehne, eine Autokonsole, eine Autoinstrumententafel, ein Autohandschuhfach, eine Autokofferraumklappe oder eine Autokofferraumverkleidung oder ein Kindersitz für Autos oder ein elektrisches Haushaltsgerät ist.

## Revendications

1. Un article moulé pouvant être obtenu par moulage par injection d'une structure multicouche textile, la structure multicouche textile comprenant les couches suivantes empilées dans l'ordre mentionné ci-dessous :
un tissu textile laminé extérieur (1);
un matériau bi-adhésif optionnel (2) ; et
un film laminé (3, 7, 4, 5), dans lequel ledit film laminé comprend : un ou plusieurs circuit(s) imprimé(s) conducteur(s) (7), une couche d'encapsulation pour l'encapsulation de circuits imprimés (3); une couche de film polymère (4), sur le côté où un ou plusieurs circuit(s) imprimé(s) conducteur(s) (7) est(sont) imprimé(s) ;
une couche de tissu non-tissé adhésif (5) pour stabiliser et protéger le circuit électrique imprimé durant le processus de moulage par injection, dans laquelle la couche de tissu non-tissé adhésif (5) a une épaisseur située entre 200 - 300 µm; tel que les couches de la structure multicouche textile sont attachées les unes aux autres ;
dans lequel le tissu textile laminé extérieur (1) et le film laminé (3, 7, 4, 5) ont été attachés à l'aide d'un moulage par injection de ceux-ci.

2. L'article moulé selon l'une quelconque des revendications précédentes, dans lequel la couche bi-adhésive (2) attache ledit film laminé au tissu textile laminé extérieur (1).

3. L'article moulé selon l'une quelconque des revendications précédentes, dans lequel tous les éléments du film laminé (3, 7, 4, 5) ont été laminés ensemble dans le film laminé (3, 7, 4, 5).

4. L'article moulé selon l'une quelconque des revendications 1-3, dans lequel ledit film laminé a été laminé avec le tissu textile laminé extérieur (1).

5. L'article moulé selon l'une quelconque des revendications précédentes comprenant un ou plusieurs composant(s) électronique(s) disposé(s) du même côté que la couche de tissu non-tissé adhésif (5) ou que la couche de film polymère (4) et disposé sur le circuit ou les circuits imprimé(s), lesdits composants étant électriquement connectés audit circuit ou auxdits circuits imprimé(s) et lesdits composants électroniques ayant également été laminés avec le film laminé.

6. L'article moulé selon l'une quelconque des revendications précédentes, dans lequel les composants électroniques sont une diode émettrice de lumière, une lampe électroluminescente, une résistance électrique, un capteur de résistance, un élément de sertissage ou des combinaisons de ceux-ci.

7. L'article moulé selon l'une quelconque des revendications précédentes, dans lequel la couche de tissu textile (1) est une combinaison d'au moins deux couches de tissu, de préférence dans lequel la combinaison d'au moins 2 couches de tissu est: un tricot en tant que textile décoratif et un tissu non-tissé, ou un tissu tissé en tant que textile décoratif et un tissu non-tissé.

8. L'article moulé selon l'une quelconque des revendications précédentes, dans lequel la couche d'encapsulation (3) et/ou la couche de film polymère (4) a une épaisseur allant de 20 à 70 µm, de préférence 50 µm.

9. L'article moulé selon l'une quelconque des revendications précédentes, dans lequel la couche d'encapsulation (3) et/ou la couche de film polymère (4) a une densité à 20 °C allant de 1,1 à 1,2 g/cm³.

10. L'article moulé selon l'une quelconque des revendications précédentes, dans lequel la couche d'encapsulation (3) et/ou la couche de film polymère (4) a une plage de température de fusion de 145 à 210 °C.

11. L'article moulé selon l'une quelconque des revendications précédentes, dans lequel la couche d'encapsulation (3) et/ou la couche de film polymère (4) est sélectionnée à partir d'une liste consistant en polyuréthane, polyester, polyamide, polyéther, éthylène-acétate de vinyle ou des combinaisons de ceux-ci.

12. L'article moulé selon l'une quelconque des revendications précédentes, dans lequel la couche bi-adhésive (2) a une plage de température de fusion entre 115 - 143 °C et/ou la couche bi-adhésive (2) a un poids situé entre 5 - 50 g/m², de préférence 20 g/m².

13. L'article moulé selon l'une quelconque des revendications précédentes, dans lequel l'article est un pilier de voiture, un panneau de porte de voiture, une porte de voiture, un accoudoir de voiture, une console de voiture, un tableau de bord de voiture, une boîte à gants de voiture, une porte de coffre de voiture, ou un panneau de coffre de voiture, ou un siège auto pour bébé ou un appareil ménager électrique.
